# EUROPEAN PATENT SPECIFICATION

(11) **EP 3 211 507 B1**
(45) Date of publication and mention of the grant of the patent: **17.07.2019**
(21) Application number: 17153912.5
(22) Date of filing: 31.01.2017
(51) Int. Cl.: G06F 1/16, H04M 1/02, G03B 17/02, G03B 17/12, G03B 5/00, H04N 5/225, H05K 1/02, H05K 1/11

(54) **CAMERA ASSEMBLY AND ELECTRONIC DEVICE**
KAMERAANORDNUNG UND ELEKTRONISCHE VORRICHTUNG
ENSEMBLE CAMÉRA ET APPAREIL ÉLECTRONIQUE

(30) Priority: 29.02.2016 CN 201610112889
(43) Date of publication of application: 30.08.2017
(73) Proprietor: Beijing Xiaomi Mobile Software Co., Ltd., Beijing 100085 (CN)
(72) Inventor: WU, Fenghui, BEIJING, 100085 (CN); YAN, Kesheng, BEIJING, 100085 (CN)
(74) Representative: Delumeau, François Guy

(56) References cited:
- CN-U- 202 309 797
- US-A1- 2008 002 965
- US-A1- 2008 085 112

## Description

### TECHNICAL FIELD

The present invention relates to the field of mechanical design, and more particularly to a camera assembly and an electronic device.

### BACKGROUND

A camera assembly is a common assembly in an electronic device such as a handset, a tablet computer, a notebook computer or the like. The camera assembly is used for acquiring an image or video.

The camera assembly is usually provided on the back side of an electronic device. Since the back side of the electronic device often contacts a table, the lens of the camera assembly tends to be worn and torn. In the related art, a sapphire lens is provided for the camera assembly so as to reduce the wear and tear.

CN 202 309 797 U discloses a device for ejecting a camera in a portable electronic device comprising a set casing arranged in the portable electronic device, a slide mass in the set casing, and a camera arranged on the slide mass. The device further includes a motion control mechanism for the slide mass including a spring that causes the slide mass to eject.

US 2008/085112 A1 discloses a photographic device that includes a main body, a lens barrel, and a barrel-positioning mechanism, which is operably coupled to the lens barrel and the main body. The barrel positioning mechanism is capable of moving the lens barrel between a retracted position, in which the lens barrel is within the main body, and an extended position, in which the lens barrel projects out of the main body.

### SUMMARY

In order to solve the problem that a camera assembly tends to be worn and torn, the present invention provides a camera assembly and an electronic device as defined in the appended claims.

According to a first aspect of embodiments, the invention relates to a camera assembly, comprising: a housing, a camera component provided inside the housing and a press-type PUSH-PUSH component provided inside the housing. One end of the PUSH-PUSH component is connected to the housing and the other end thereof is connected to the camera component; a sliding groove is formed inside the housing for the camera component to slide therealong; and the camera component is configured to, when receiving a press operation, switch between a first state of protruding from the housing and a second state of retracting inside the housing under the guidance of the PUSH-PUSH component.

In a particular embodiment, the camera component is considered inside the housing when said camera component is partly inside the housing.

In a particular embodiment, the PUSH-PUSH component comprises a hook element, an elastic component and a heart-shaped sliding groove part. A tail of the hook element is connected to the housing, and a head of the hook element is disposed in the heart-shaped sliding groove part. The elastic component is disposed between the housing and the heart-shaped sliding groove part, and the elastic component is configured to provide a push force to the heart-shaped sliding groove part along a direction from the tail to the head of the hook element. The heart-shaped sliding groove part is fixedly connected to the camera component in parallel, the heart-shaped sliding groove part includes a heart-shaped closed sliding groove, the closed sliding groove includes a first arch sliding groove and a second arch sliding groove, a top end of the first arch sliding groove meets with a top end of the second arch sliding groove to form a first depression, and a tail end of the first arch sliding groove meets with a tail end of the second arch sliding groove to form a second depression. The heart-shaped sliding groove part is configured to, after the camera component receives a press operation, slide along the
direction from the head to the tail of the hook element under the driving of the push force, so that the hook head of the hook element slides from the first depression to the second depression along the second arch sliding groove to switch the camera component from the second state of retracting inside the housing to the first state of protruding from the housing; or to slide along a direction from the head to the tail of the hook element under the driving of a press force of the press operation, so that the head of the hook element slides from the second depression to the first depression along the first arch sliding groove to switch the camera component from the first state of protruding from the housing to the second state of retracting inside the housing.

In a particular embodiment, a sliding groove for the heart-shaped sliding groove part to slide therealong is further provided inside the housing.

In a particular embodiment, the elastic component is a spring.

In a particular embodiment, the camera assembly further includes a flexible printed circuit board. One end of the flexible printed circuit board is electrically connected to the camera component and the other end thereof is connected to a processor. The flexible printed circuit board is configured to be positioned between the camera component and an inner surface of the housing in a curled state when the camera component is in the second state and to be positioned between the camera component and the inner surface of the housing in a stretched state when the camera component is in the first state.

In a particular embodiment, the camera assembly further comprises a detection switch secured to the housing, wherein the flexible printed circuit board further includes two contacts corresponding to the detection switch. The detection switch is configured to electrically connect the two contacts when the flexible printed circuit board is in the curled state to trigger the flexible printed circuit board to send a camera assembly shutdown signal to the processor; or to electrically disconnect the two contacts when the flexible printed circuit board is in the stretched state to trigger the flexible printed circuit board to send a camera assembly startup signal to the processor.

In a particular embodiment, the detection switch is a metal plate including two resilient contacts which correspond to the two contacts respectively.

According to a second aspect of the embodiments of the present invention, an electronic device is provided, comprising: a main board and a camera assembly. The camera assembly is provided on the main board; and the camera assembly is a camera assembly according to the first aspect.

In a particular embodiment, the main board is further provided with a processor which is connected to a flexible printed circuit board in the camera assembly via a conductive wire on the main board. The processor is configured to receive a camera assembly startup signal sent by the camera assembly and start a camera application according to the camera assembly startup signal, or to receive a camera assembly shutdown signal sent by the camera assembly and close the camera application according to the camera assembly shutdown signal.

In a particular embodiment, the electronic device further comprises an enclosure which is provided with an opening for exposing the camera assembly.

The technical solution provided in the embodiments of the present invention may have the following beneficial effects. The camera assembly includes a housing, a camera component provided inside the housing and a press-type PUSH-PUSH component; one end of the PUSH-PUSH component is connected to the housing and the other end thereof is connected to the camera component; a sliding groove is formed inside the housing for the camera component to slide therealong; the camera component is configured to, when receiving a press operation, switch between a first state of protruding from the housing and a second state of retracting inside the housing under the guidance of the PUSH-PUSH component. This solves the problem in the related art that the camera assembly is provided on the back side of an electronic device and the lens thereof tends to be worn since the back side of the electronic device often contacts a table is solved, and achieves the effect that the lens of the camera assembly is switchable between protruding from the housing and retracting inside the housing and thus the wear and tear of the lens is reduced.

It is to be understood that both the foregoing general description and the following detailed description are exemplary only and are not restrictive of the present invention.

### BRIEF DESCRIPTION OF THE DRAWINGS

The accompanying drawings, which are incorporated in and constitute a part of this specification, illustrate embodiments consistent with the invention and, together with the description, serve to explain the principles of the invention.
Fig. 1 is a schematic structural diagram of a camera assembly according to an exemplary embodiment.
Fig. 1A is a schematic diagram illustrating a state of a camera assembly according to an exemplary embodiment.
Fig. 2 is a schematic structural diagram of a camera assembly according to another exemplary embodiment.
Fig. 2A is a schematic structural diagram of a camera assembly according to another exemplary embodiment.
Fig. 2B is a schematic structural diagram of a camera assembly according to another exemplary embodiment.
Fig. 2C is a schematic structural diagram of a camera assembly according to another exemplary embodiment.
Fig. 2D is a schematic structural diagram of a camera assembly according to another exemplary embodiment.
Fig. 3A is a schematic diagram illustrating a state of a camera assembly according to an exemplary embodiment.
Fig. 3B is a schematic diagram illustrating a state of a camera assembly according to another exemplary embodiment.
Fig. 4 is a schematic structural diagram of a camera assembly according to another exemplary embodiment.
Fig. 5 is a schematic structural diagram of an electronic device according to an exemplary embodiment.
Fig. 6 is a schematic structural diagram of an electronic device according to another exemplary embodiment.

### DETAILED DESCRIPTION

Here, exemplary embodiments will be described in detail, examples of which are illustrated in the accompanying drawings. The following description refers to the accompanying drawings in which the same or similar numbers in different drawings represent the same or similar elements unless otherwise indicated. The implementations set forth in the following description of exemplary embodiments do not represent all implementations consistent with the present invention. Instead, they are merely examples of apparatuses and methods consistent with aspects related to the present invention as recited in the appended claims.

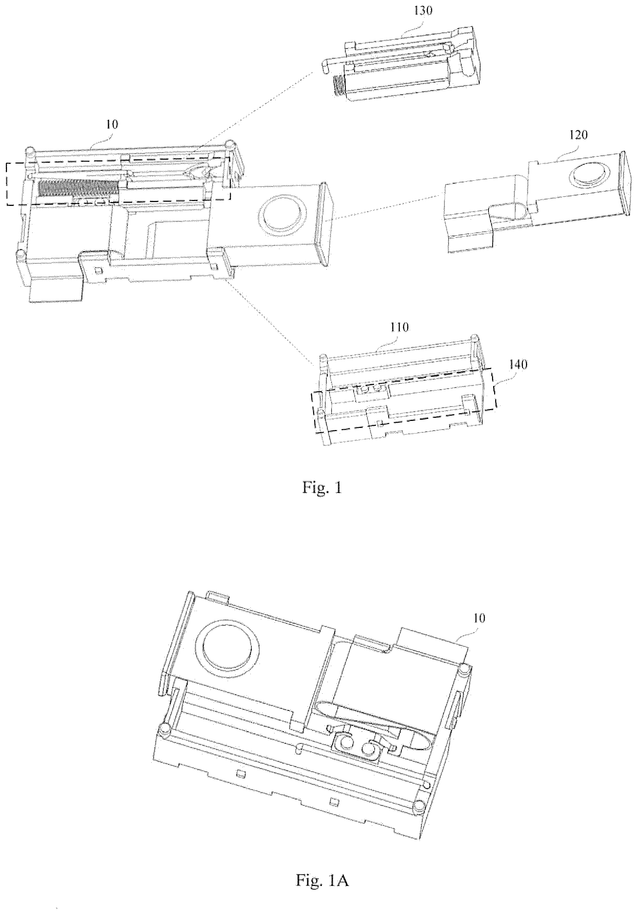

Fig. 1 is a schematic structural diagram of a camera assembly according to an exemplary embodiment. The camera assembly may be a camera assembly in an electronic device such as a handset, a tablet computer, a notebook computer or the like. As shown in Fig. 1, a camera assembly 10 includes: a housing 110, a camera component 120 provided inside the housing 110 and a PUSH-PUSH (press-type) component 130 provided inside the housing 110.

One end of the PUSH-PUSH component 130 is connected to the housing 110 and the other end thereof is connected to the camera component 120.

A sliding groove 140 is formed inside the housing 110 for the camera component 120 to slide.

The camera component 120 is configured to, when receiving a press operation, switch between a first state of protruding from the housing 110 and a second state of retracting inside the housing 110 under the guidance of the PUSH-PUSH component 130.

Fig. 1 is a schematic diagram of the camera assembly 10 when the camera component 120 is in the first state, and Fig. 1A is a schematic diagram of the camera assembly 10 when the camera component 120 is in the second state (the PUSH-PUSH component 130 is not shown in Fig. 1A).

In summary, the camera assembly provided in the embodiment of the present invention includes a housing, a camera component provided inside the housing and a press-type PUSH-PUSH component; one end of the PUSH-PUSH component is connected to the housing and the other end thereof is connected to the camera component; a sliding groove is formed inside the housing for the camera component to slide therealong; the camera component is configured to, when receiving a press operation, switch between a first state of protruding from the housing and a second state of retracting inside the housing under the guidance of the PUSH-PUSH component. This solves the problem in the related art that the camera assembly is provided on the back side of an electronic device and the lens thereof tends to be worn since the back side of the electronic device often contacts a table, and achieves the effect that the lens of the camera assembly can be switched between protruding from the housing and retracting inside the housing and thus not only the usage of the camera assembly will not be affected but also the wear and tear of the lens can be reduced.

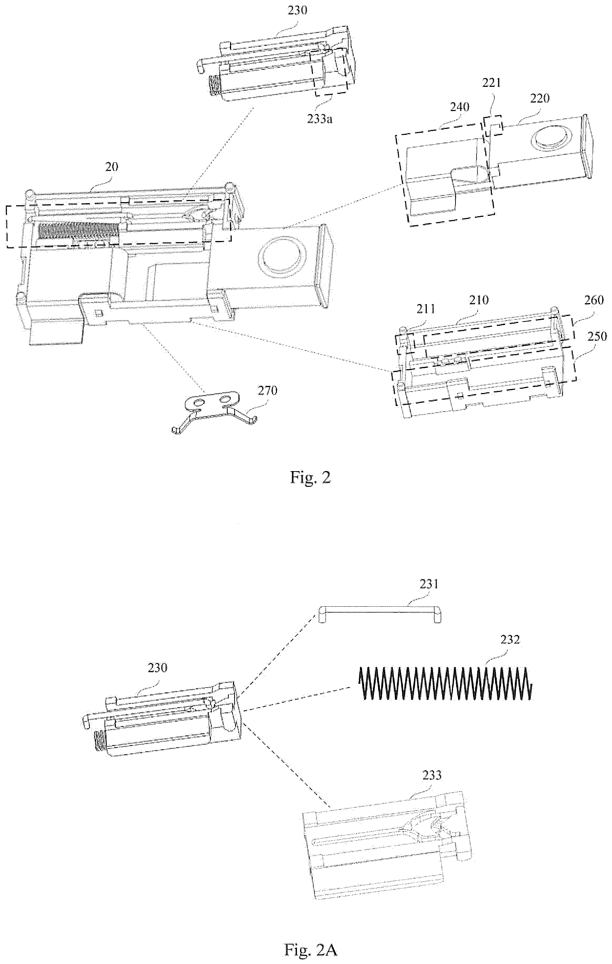

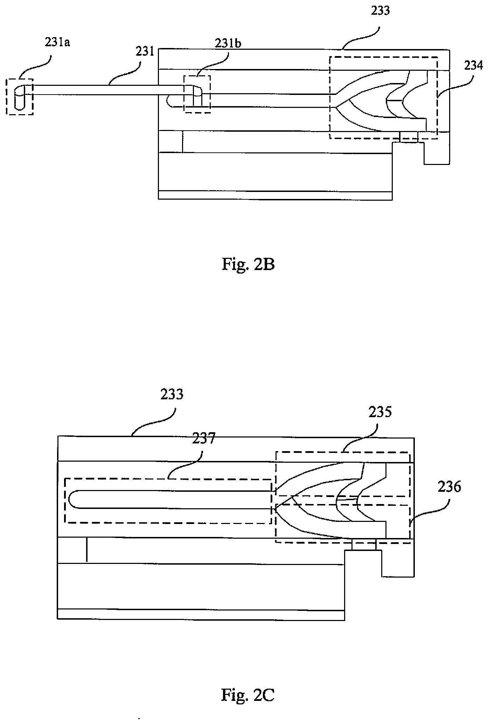

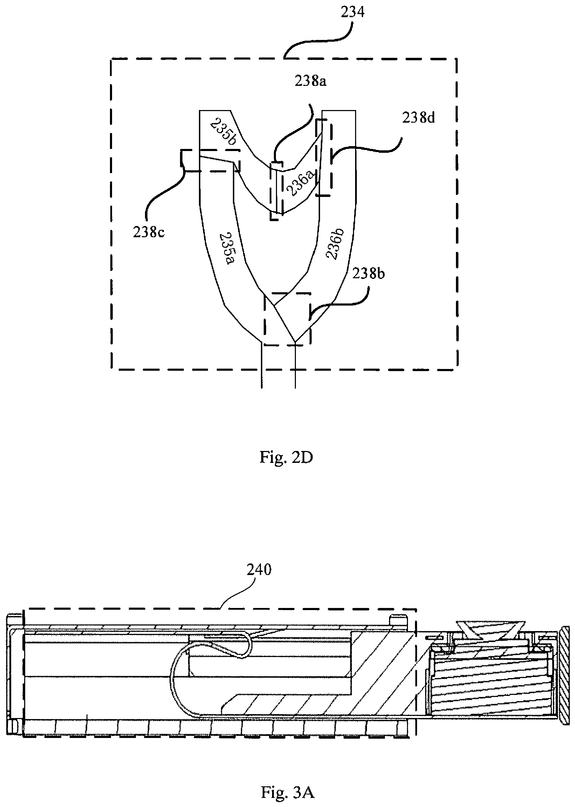

Fig. 2 is a schematic structural diagram of a camera assembly according to an exemplary embodiment. The camera assembly may be a camera assembly in an electronic device such as a handset, a tablet computer, a notebook computer or the like. As shown in Fig. 2, a camera assembly 20 includes: a housing 210, a camera component 220 provided inside the housing 210 and a PUSH-PUSH component 230 provided inside the housing 210.

In a particular embodiment, the camera assembly 20 further includes a flexible printed circuit board 240.

In a particular embodiment, one end of the flexible printed circuit board 240 is electrically connected to the camera component 220 and the other end thereof is connected to a processor.

One end of the PUSH-PUSH component 230 is connected to the housing 210 and the other end thereof is connected to the camera component 220.

In a particular embodiment, the housing 210 is of a cuboid shape, and the camera component 220 and the PUSH-PUSH component 230 are provided inside the housing in parallel. The shape of the housing is not limited in this embodiment.

In a particular embodiment, the PUSH-PUSH component 230 includes a hook element 231, an elastic component 232 and a heart-shaped sliding groove part 233, as shown in Fig. 2A.

In a particular embodiment, the elastic component 232 is a spring.

The tail 231a of the hook element 231 is connected to the housing 210, and the head 231b of the hook element 231 is disposed in the heart-shaped sliding groove part 233, as shown in Fig. 2B.

In a particular embodiment, the tail 231a and the head 231b of the hook element 231 are each of a curved shape so that the tail 231a of the hook element 231 is disposed in a small hole 211 of the housing 210 and connected to the housing.

In a particular embodiment, the tail 231a of the hook element 231 is connected to the housing 210 at a fixed location, and the head 231b is disposed inside the heart-shaped sliding groove part 233 and is movable perpendicularly to the direction from the tail (231a) to the head (231b).

A sliding groove 250 is formed inside the housing 210 for the camera component 220 to slide therealong.

In a particular embodiment, the camera component 220 is provided in the sliding groove 250 and can slide along the sliding groove 250.

In a particular embodiment, a sliding groove for the heart-shaped sliding groove part 233 to slide therealong is further provided inside the housing 210, and the sliding groove 260 and the sliding groove 250 are provided in parallel.

In a particular embodiment, the heart-shaped sliding groove part 233 is provided in the sliding groove 260 and can slide along the sliding groove 260.

In a particular embodiment, a recess 233a of the heart-shaped sliding groove part 233 and a projection 221 of the camera component 220 are engaged fixedly in parallel so that the other end of the PUSH-PUSH component 230 is connected to the camera component 220. The method and the location for engaging the camera component 220 and the heart-shaped sliding groove part 233 are not limited in this embodiment.

In a particular embodiment, the sliding direction of the heart-shaped sliding groove part 233 is the same as that of the camera component 220.

The heart-shaped sliding groove part 233 includes a heart-shaped closed sliding groove 234. The shape of the closed sliding groove 234 is not limited in this embodiment.

In a particular embodiment, the closed sliding groove 234 includes a first arch sliding groove 235 and a second arch sliding groove 236, as shown in Fig. 2C.

In a particular embodiment, the heart-shaped sliding groove part 233 further includes a third sliding groove 237 which is connected to the closed sliding groove 234. Specifically, the third sliding groove 237 is connected to the tail end of the first arch sliding groove 235 and the tail end of the second arch sliding groove 236.

In a particular embodiment, the top end of the first arch sliding groove 235 and the top end of the second arch sliding groove 236 meet to form a first depression 238a, as shown in Fig. 2D; and at the intersection, the top end of the first arch sliding groove 235 is higher than that of the second arch sliding groove 236.

In a particular embodiment, the tail end of the first arch sliding groove 235 and the tail end of the second arch sliding groove 236 meet to form a second depression 238b; and at the intersection, the tail end of the second arch sliding groove 236 is higher than that of the first arch sliding groove 235.

In a particular embodiment, if the third sliding groove 237 exists, when the hook head 231b moves to the second depression 238b, it continues to slide into the third sliding groove 237.

In a particular embodiment, the first arch sliding groove 235 includes a first curved sliding groove 235a and a second curved sliding groove 235b. The first curved sliding groove 235a and the second curved sliding groove 235b meet to form a third depression 238c; and at the intersection, the first curved sliding groove 235a is higher than the second curved sliding groove 235b.

In a particular embodiment, the second arch sliding groove 236 includes a third curved sliding groove 236a and a fourth curved sliding groove 235b. The third curved sliding groove 236a and the fourth curved sliding groove 235b meet to form a fourth depression 238c, and at the intersection, the third curved sliding groove 236a is higher than the fourth curved sliding groove 235b.

In a particular embodiment, when the hook head 231b of the hook element 231 is located at the second depression 238b or the third sliding groove 237, the camera component 220 connected to the heart-shaped sliding groove part 233 protrudes from the housing 210, which is the first state of the camera component 220.

In a particular embodiment, the flexible printed circuit board 240 is configured to be positioned between the camera component 220 and the inner surface of the housing 210 in a stretched state when the camera component 220 is in the first state, as shown in Fig. 3A.

In a particular embodiment, when the head 231b of the hook element 231 is located at the first depression 238a, the camera component 220 connected to the heart-shaped sliding groove part 233 retracts inside the housing 210, which is the second state of the camera component 220.

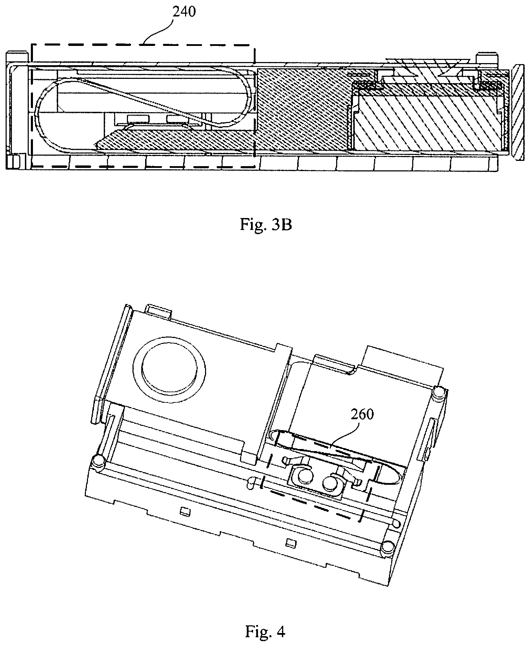

In a particular embodiment, the flexible printed circuit board 240 is configured to be positioned between the camera component 220 and the inner surface of the housing 210 in a curled state when the camera component 220 is in the second state, as shown in Fig. 3B.

In a particular embodiment, the other end of the flexible printed circuit board 240 connected to the processor protrudes from a side of the housing 210 along a direction perpendicular to the sliding direction of the camera component 220. When the flexible printed circuit board 240 is positioned between the camera component 220 and the inner surface of the housing 210 in a stretched state or a curled state, the other end of the flexible printed circuit board connected to the processor is stationary.

The elastic component 232 is disposed between the housing 210 and the heart-shaped sliding groove part 233.

In a particular embodiment, the elastic component 232 is disposed between the housing and the tail end of the heart-shaped sliding groove part 233, the tail end of the heart-shaped sliding groove part 233 being an end close to the tail ends of the first arch sliding groove 235 and the second arch sliding groove 236. When the hook head 231b of the hook element 231 is located at the second depression 238b or the third sliding groove 237, the camera component 220 is in the first state and the elastic component 232 is of the original length. When the hook head 231b of the hook element 231 is located at the first depression 238a, the camera component 220 is in the second state and the elastic component 232 is in a compressed state for providing a push force to the heart-shaped sliding groove part 233 along the direction from the tail 231a to the head 231b of the hook element 231.

In a particular embodiment, the elastic component 232 is disposed between the housing and the top end of the heart-shaped sliding groove part 233, the top end of the heart-shaped sliding groove part 233 being an end close to the top ends of the first arch sliding groove 235 and the second arch sliding groove 236. When the hook head 231b of the hook element 231 is located at the second depression 238b or the third sliding groove 237, the camera component 220 is in the first state and the elastic component 232 is of the original length. When the hook head 231b of the hook element 231 is located at the first depression 238a, the camera component 220 is in the second state and the elastic component 232 is in a stretched state for providing a pull force to the heart-shaped sliding groove part 233 along the direction from the tail 231a to the head 231b of the hook element 231.

The location of the elastic component 232 is not limited in this embodiment, and the elastic component 232 being disposed between the housing 210 and the tail end of the heart-shaped sliding groove part 233 is taken as an example.

In a particular embodiment, the camera assembly 20 further includes a detection switch 260 secured to the housing 210.

In a particular embodiment, the flexible printed circuit board 240 further includes two contacts corresponding to the detection switch 260.

In a particular embodiment, the detection switch 260 is a metal plate including two resilient contacts which correspond to the two contacts on the flexible printed circuit board 240 respectively.

In a particular embodiment, the detection switch 260 is configured to electrically connect the two contacts when the flexible printed circuit board 240 is in the curled state and the camera component 220 is in the second state to trigger the flexible printed circuit board to send a camera assembly shutdown signal to the processor so that the camera assembly 20 stops working, as shown in Fig. 4.

In a particular embodiment, the detection switch 260 is configured to electrically disconnect the two contacts when the flexible printed circuit board 240 is in the stretched state and the camera component 220 is in the first state to trigger the flexible printed circuit board to send a camera assembly startup signal to the processor so that the camera assembly 20 works.

The camera component 220 is configured to, when receiving a press operation, switch between a first state of protruding from the housing 210 and a second state of retracting inside the housing 210 under the guidance of the PUSH-PUSH component 230.

In a possible embodiment, the camera component 220 is in a first state. The heart-shaped sliding groove part 233 is configured to, after the camera component 220 receives a press operation, slide along the direction from the head 231b to the tail 231a of the hook element 231 under the driving of a press force of the press operation, so that the hook head 231b of the hook element 231 slides from the second depression 238b to the first depression along the first arch sliding groove to switch the camera component from the first state of protruding from the housing to the second state of retracting inside the housing.

In a particular embodiment, when the camera component 220 is in a first state, the hook head 231b of the hook element 231 is located at the second depression 238b or the third sliding groove 237. Since at the second depression 238b the second arch sliding groove 236 is higher than the first arch sliding groove 235, after the camera component 220 receives a press operation, the heart-shaped sliding groove part 233 slides along direction from the head 231b the tail 231a of the hook element 231, so that the hook head 231b slides to the third depression 238c along the first arch sliding groove 235. Since at the third depression 238c the first curved sliding groove is higher than the second curved sliding groove 235b, the hook head 231b slides to the first depression 238a along the second curved sliding groove 235b and stays at the first depression 238a, so that the elastic component 232 is in a compressed state. Accordingly, the heart-shaped sliding groove part 233 guides the camera component 220 to slide along the direction from the head 231b to the tail 231a of the hook element 231, and the camera component 220 switches to the second state of retracting inside the housing.

In another possible embodiment, the camera component 220 is in a second state. The heart-shaped sliding groove part 233 is configured to, after the camera component 220 receives a press operation, slide along the direction from the tail 231a to the head 231b of the hook element 231 under the driving of the push force so that the hook head 231b of the hook element 231 slides from the first depression 238a to the second depression 238b along the second arch sliding groove 236 to switch the camera component 220 from the second state of retracting inside the housing to the first state of protruding from the housing.

In a particular embodiment, when the camera component 220 is in a second state, the hook head 231b of the hook element 231 is located at the first depression 238a. After the camera component 220 receives a press operation, the hook head 231b of the hook element 231 slides to the fourth depression 238b along the third curved sliding groove. Since the third curved sliding groove 236a is higher than the fourth curved sliding groove 236b at the fourth depression 238b, the heart-shaped sliding groove part 233 slides along the direction from the tail 231a to the head 231b under the driving of the push force of the elastic component 232, so that the hook head 231b slides to the second depression 238b along the fourth curved sliding groove 236b and continues to slide to the third sliding groove 237 such that the elastic component 232 returns to the original length. Accordingly, the heart-shaped sliding groove part 233 guides the camera component 220 to slide along the direction from the tail 231a to the head 231b of the hook element 231, and the camera component 220 switches to the first state of protruding from the housing.

In summary, the camera assembly provided in the embodiments of the present invention includes a housing, a camera component provided inside the housing and a press-type PUSH-PUSH component; one end of the PUSH-PUSH component is connected to the housing and the other end thereof is connected to the camera component; a sliding groove is formed inside the housing for the camera component to slide therealong; the camera component is configured to, when receiving a press operation, switch between a first state of protruding from the housing and a second state of retracting inside the housing under the guidance of the PUSH-PUSH component. This solves the problem in the related art that the camera assembly is provided on the back side of an electronic device and the lens thereof tends to be worn since the back side of the electronic device often contacts a table, and achieves the effect that the lens of the camera assembly can be switched between protruding from the housing and retracting inside the housing and thus the wear and tear of the lens can be reduced.

In summary, according to the camera assembly in the embodiments of the present invention, a camera assembly shutdown signal is sent when the camera component retracts inside the housing, and a camera assembly startup signal is sent when the camera component protrudes from the housing, thereby achieving the effect of not affecting the usage of the camera assembly.

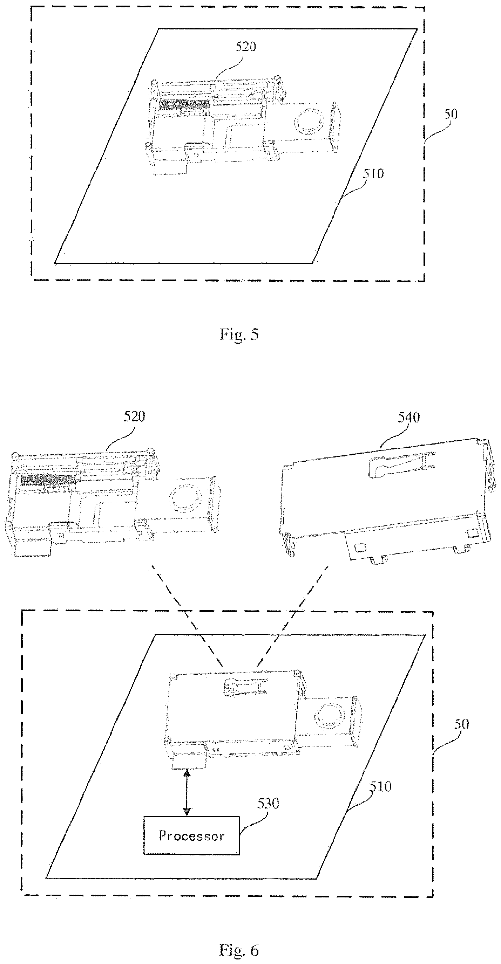

Fig. 5 is a schematic structural diagram of an electronic device according to another exemplary embodiment. As shown in Fig. 5, an electronic device 50 includes a main board 510 and a camera assembly 520.

In a particular embodiment, the camera assembly 520 is a camera assembly shown in any one of Figs. 2 to 4, which will not be described redundantly in this embodiment.

In a particular embodiment, the camera assembly 500 is provided on the main board 510.

In a particular embodiment, in other embodiments based on the above embodiment, the electronic device 50 further includes a processor 530 as shown in Fig. 6.

In a particular embodiment, the main board 510 is further provided with the processor 530 which is connected to the flexible printed circuit board in the camera assembly via a conductive wire on the main board 510.

In a particular embodiment, the processor 530 is configured to receive a camera assembly startup signal sent by the camera assembly 520 and start a camera application according to the camera assembly startup signal, or to receive a camera assembly shutdown signal sent by the camera assembly 520 and close the camera application according to the camera assembly shutdown signal.

In a particular embodiment, the electronic device 50 further comprises an enclosure 540 which is provided with an opening for exposing the camera assembly 520.

In summary, the electronic device provided in the embodiments of the present invention includes a main board, a camera assembly, a processor and an enclosure; the camera assembly and the processor are provided on the main board; the processor is connected to a flexible printed circuit board in the camera assembly via a conductive wire on the main board, and is configured to receive a camera assembly startup signal sent by the camera assembly and start a camera application according to the camera assembly startup signal or to receive a camera assembly shutdown signal sent by the camera assembly and close the camera application according to the camera assembly shutdown signal. This solves the problem in the related art that the camera assembly is provided on the back side of an electronic device and the lens thereof tends to be worn since the back side of the electronic device often contacts a table, and achieves the effect that the camera application is started when the lens of the camera component protrudes from the housing and is closed when the lens of the camera component retracts inside the housing and thus not only the usage of the camera assembly will not be affected but also the wear and tear of the lens can be reduced.

Other embodiments of the present invention will be apparent to those skilled in the art from consideration of the specification and practice of the present invention disclosed here. This application is intended to cover any variations, uses, or adaptations of the present invention following the general principles thereof and including such departures from the present invention as come within known or customary practice in the art. It is intended that the specification and embodiments be considered as exemplary only, with a true scope of the present invention being indicated by the appended claims.

It will be appreciated that the present invention is not limited to the exact construction that has been described above and illustrated in the accompanying drawings, and that various modifications and changes can be made without departing from the scope thereof. It is intended that the scope of the present invention is only limited by the appended claims.

## Claims

1. A camera assembly (10), comprising: a housing (110; 210), a camera component (120; 220) provided inside the housing (110; 210) and a press-type PUSH-PUSH component (130; 230) provided inside the housing (110; 210), wherein
one end of the PUSH-PUSH component (130; 230) is connected to the housing (110; 210) and the other end thereof is connected to the camera component (120; 220), wherein the PUSH-PUSH component (130) further comprises a hook element (231), an elastic component (232) and a heart-shaped sliding groove part (233),
a tail (231a) of the hook element (231) is connected to the housing (210), and a head (231b) of the hook element is disposed in the heart-shaped sliding groove part (233),
the elastic component (232) is disposed between the housing and the heart-shaped sliding groove part (233), and the elastic component (232) is configured to provide a push force to the heart-shaped sliding groove part (233) along a direction from the tail (231a) to the head (231b) of the hook element (231),
the heart-shaped sliding groove part (233) is provided in a sliding groove (260) provided inside the housing (210) for the heart-shaped sliding groove part (233) to slide therealong and slides along the sliding groove (260),
the heart-shaped sliding groove part (233) is fixedly connected in parallel to the camera component (220), the heart-shaped sliding groove part (233) includes a heart-shaped closed sliding groove (234), the closed sliding groove (234) includes a first arch sliding groove (235) and a second arch sliding groove (236), a top end of the first arch sliding groove (235) meets with a top end of the second arch sliding groove (236) to form a first depression (238a), and a tail end of the first arch sliding groove (235) meets with a tail end of the second arch sliding groove (236) to form a second depression (238b),
the heart-shaped sliding groove part (233) is configured to, after the camera component (220) receives a press operation,
slide along the direction from the tail (231a) to the head (231b) of the hook element (231) under the driving of the push force, so that the head (231b) of the hook element (231) slides from the first depression (238a) to the second depression (238b) along the second arch sliding groove (236) to switch the camera component (220) from the second state of retracting inside the housing (210) to the first state of protruding from the housing (210), or
slide along a direction from the head (231b) to the tail (231a) of the hook element (231) under the driving of a press force of the press operation, so that the head (231b) of the hook element (231) slides from the second depression (238b) to the first depression (238a) along the first arch sliding groove (235) to switch the camera component (220) from the first state of protruding from the housing (210) to the second state of retracting inside the housing (210);
a sliding groove (140; 250) is formed inside the housing for the camera component (120; 220) to slide therealong, wherein the sliding groove (140; 250) for the camera component (120; 220) to slide therealong and the sliding groove (260) for the heart-shaped sliding groove part (233) to slide therealong are provided in parallel; and
the camera component (120; 220) is configured to, when receiving a press operation, switch between a first state of protruding from the housing (110; 210) and a second state of retracting inside the housing (110; 210) under the guidance of the PUSH-PUSH component (130; 230).

2. The camera assembly (10) according to claim 1, wherein the elastic component (232) is a spring.

3. The camera assembly (10) according to any of claims 1 to 2, further comprising a flexible printed circuit board (240), wherein
one end of the flexible printed circuit board (240) is electrically connected to the camera component (220) and the other end thereof is connected to a processor; and
the flexible printed circuit board (240) is configured to be positioned between the camera component (220) and an inner surface of the housing (210) in a curled state when the camera component (220) is in the second state and to be positioned between the camera component (220) and the inner surface of the housing (210) in a stretched state when the camera component (220) is in the first state.

4. The camera assembly according to claim 3, further comprising a detection switch (260) secured to the housing (210), wherein the flexible printed circuit board (240) further includes two contacts corresponding to the detection switch (260),
the detection switch (260) is configured to
electrically connect the two contacts when the flexible printed circuit board (240) is in the curled state to trigger the flexible printed circuit board (240) to send a camera assembly shutdown signal to the processor; or
electrically disconnect the two contacts when the flexible printed circuit board (240) is in the stretched state to trigger the flexible printed circuit board (240) to send a camera assembly startup signal to the processor.

5. The camera assembly according to claim 4, wherein the detection switch (260) is a metal plate including two resilient contacts which correspond to the two contacts respectively.

6. An electronic device (50), comprising: a main board (510) and a camera assembly (520), wherein
the camera assembly (520) is provided on the main board (510); and
the camera assembly (520) is a camera assembly according to any one of claims 1 to 5.

7. The electronic device (50) according to claim 6, wherein the main board (510) is further provided with a processor (530) which is connected to a flexible printed circuit board in the camera assembly (520) via a conductive wire on the main board (510);
the processor (530) is configured to receive a camera assembly startup signal sent by the camera assembly (520) and start a camera application according to the camera assembly startup signal or to receive a camera assembly shutdown signal sent by the camera assembly (520) and close the camera application according to the camera assembly shutdown signal.

8. The electronic device (50) according to claim 6 or 7, further comprising an enclosure (540) which is provided with an opening for exposing the camera assembly (520).

## Patentansprüche

1. Kameraanordnung (10), umfassend: ein Gehäuse (110; 210), eine Kamerakomponente (120; 220), die innerhalb des Gehäuses (110; 210) vorgesehen ist, und eine DRÜCK-DRÜCK-Komponente (130; 230) vom Drucktyp, die innerhalb des Gehäuses (110; 210) vorgesehen ist, wobei
ein Ende der DRÜCK-DRÜCK-Komponente (130; 230) mit dem Gehäuse (110; 210) verbunden ist und das andere Ende davon mit der Kamerakomponente (120; 220) verbunden ist, wobei die PUSH-PUSH-Komponente (130) ferner ein Hakenelement (231), eine elastische Komponente (232) und ein herzförmiges Gleitnutteil (233) umfasst,
ein Schwanz (231a) des Hakenelements (231) mit dem Gehäuse (210) verbunden ist und ein Kopf (231b) des Hakenelements in dem herzförmigen Gleitnutteil (233) angeordnet ist,
die elastische Komponente (232) zwischen dem Gehäuse und dem herzförmigen Gleitnutteil (233) angeordnet ist und die elastische Komponente (232) dazu ausgestaltet ist, eine Druckkraft auf das herzförmige Gleitnutteil (233) entlang einer Richtung von dem Schwanz (231a) zu dem Kopf (231b) des Hakenelements (231) vorzusehen,
das herzförmige Gleitnutteil (233) in einer Gleitnut (260) vorgesehen ist, die innerhalb des Gehäuses (210) vorgesehen ist, damit das herzförmige Gleitnutteil (233) an diesem entlang gleitet und entlang der Gleitnut (260) gleitet,
das herzförmige Gleitnutteil (233) parallel zu der Kamerakomponente (220) fest verbunden ist, wobei das herzförmige Gleitnutteil (233) eine herzförmige geschlossene Gleitnut (234) beinhaltet, wobei die geschlossene Gleitnut (234) eine erste Bogengleitnut (235) und eine zweite Bogengleitnut (236) beinhaltet und ein oberes Ende der ersten Bogengleitnut (235) auf ein oberes Ende der zweiten Bogengleitnut (236) trifft, um eine erste Vertiefung (238a) auszubilden, und wobei ein Schwanzende der ersten Bogengleitnut (235) auf ein Schwanzende der zweiten Bogengleitnut (236) trifft, um eine zweite Vertiefung (238b) auszubilden,
das herzförmige Gleitnutteil (233) dazu ausgestaltet ist, nachdem die Kamerakomponente (220) eine Drückbetätigung erfährt,
entlang der Richtung von dem Schwanz (231a) zu dem Kopf (231b) des Hakenelements (231) unter dem Antrieb der Druckkraft zu gleiten, so dass der Kopf (231b) des Hakenelements (231) von der ersten Vertiefung (238a) zu der zweiten Vertiefung (238b) entlang der zweiten Bogengleitnut (236) gleitet, um die Kamerakomponente (220) von dem zweiten Zustand des Einfahrens in das Gehäuse (210) in den ersten Zustand des Herausragens von dem Gehäuse (210) zu versetzen, oder
entlang einer Richtung von dem Kopf (231b) zu dem Schwanz (231a) des Hakenelements (231) unter dem Antrieb einer Druckkraft zu gleiten, so dass der Kopf (231b) des Hakenelements (231) von der zweiten Vertiefung (238b) zu der ersten Vertiefung (238a) entlang der ersten Bogengleitnut (235) gleitet, um die Kamerakomponente (220) von dem ersten Zustand des Herausragens von dem Gehäuse (210) in den zweiten Zustand des Einfahrens in das Gehäuse (210) zu versetzen,
eine Gleitnut (140; 250) innerhalb des Gehäuses für die Kamerakomponente (120; 220) ausgebildet wird, um an dieser entlang zu gleiten, wobei die Gleitnut (140; 250) für die Kamerakomponente (120; 220), um an dieser entlang zu gleiten, und die Gleitnut (260) für das herzförmige Gleitnutteil (233), um an diesem entlang zu gleiten, parallel vorgesehen sind, und
die Kamerakomponente (120; 220) dazu ausgestaltet ist, wenn sie eine Drückbetätigung erfährt, zwischen einem ersten Zustand des Herausragens von dem Gehäuse (110; 210) und einem zweiten Zustand des Einfahrens in das Gehäuse (110; 210) unter der Führung der DRÜCK-DRÜCK-Komponente (130; 230) zu wechseln.

2. Kameraanordnung (10) nach Anspruch 1, wobei die elastische Komponente (232) eine Feder ist.

3. Kameraanordnung (10) nach einem der Ansprüche 1 bis 2, ferner umfassend eine flexible Leiterplatte (240), wobei
ein Ende der flexiblen Leiterplatte (240) elektrisch mit der Kamerakomponente (220) verbunden ist und das andere Ende davon mit einem Prozessor verbunden ist und
die flexible Leiterplatte (240) dazu ausgestaltet ist, zwischen der Kamerakomponente (220) und einer inneren Fläche des Gehäuses (210) in einem eingerollten Zustand positioniert zu werden, wenn sich die Kamerakomponente (220) in dem zweiten Zustand befindet, und zwischen der Kamerakomponente (220) und der inneren Fläche des Gehäuses (210) in einem ausgestreckten Zustand positioniert zu werden, wenn sich die Kamerakomponente (220) in dem ersten Zustand befindet.

4. Kameraanordnung (10) nach Anspruch 3, ferner umfassend einen Detektionsschalter (260), der an dem Gehäuse (210) befestigt ist, wobei die flexible Leiterplatte (240) ferner zwei Kontakte beinhaltet, die dem Detektionsschalter (260) entsprechen,
wobei der Detektionsschalter (260) dazu ausgestaltet ist,
die beiden Kontakte elektrisch zu verbinden, wenn sich die flexible Leiterplatte (240) in dem eingerollten Zustand befindet, um die flexible Leiterplatte (240) zu veranlassen, ein Kameraanordnungsabschaltsignal an den Prozessor zu senden, oder
die beiden Kontakte elektrisch zu trennen, wenn sich die flexible Leiterplatte (240) in dem ausgestreckten Zustand befindet, um die flexible Leiterplatte (240) zu veranlassen, ein Kameraanordnungsstartsignal an den Prozessor zu senden.

5. Kameraanordnung (10) nach Anspruch 4, wobei der Detektionsschalter (260) eine Metallplatte ist, die zwei nachgiebige Kontakte beinhaltet, die jeweils den beiden Kontakten entsprechen.

6. Elektronische Vorrichtung (50), umfassend: eine Hauptplatine (510) und eine Kameraanordnung (520), wobei
die Kameraanordnung (520) auf der Hauptplatine (510) vorgesehen ist und
die Kameraanordnung (520) eine Kameraanordnung nach einem der Ansprüche 1 bis 5 ist.

7. Elektronische Vorrichtung (50) nach Anspruch 6, wobei die Hauptplatine (510) ferner mit einem Prozessor (530) versehen ist, der mit einer flexiblen Leiterplatte in der Kameraanordnung (520) über einen leitfähigen Draht auf der Hauptplatine (510) verbunden ist,
wobei der Prozessor (530) dazu ausgestaltet ist, ein Kameraanordnungsstartsignal, das von der Kameraanordnung (520) gesendet wird, zu empfangen und eine Kameraanwendung in Übereinstimmung mit dem Kameraanordnungsstartsignal zu starten oder ein Kameraanordnungsabschaltsignal, das von der Kameraanordnung (520) gesendet wird, zu empfangen und die Kameraanwendung in Übereinstimmung mit dem Kameraanordnungsabschaltsignal zu schließen.

8. Elektronische Vorrichtung (50) nach Anspruch 6 oder 7, ferner umfassend eine Hülle (540), die mit einer Öffnung zum Freilegen der Kameraanordnung (520) versehen ist.

## Revendications

1. Ensemble caméra (10), comprenant : un boîtier (110 ; 210), un élément caméra (120 ; 220) prévu à l'intérieur du boîtier (110 ; 210) et un élément à double poussée du type à enfoncement (130 ; 230) prévu à l'intérieur du boîtier (110 ; 210), dans lequel
une extrémité de l'élément à double poussée (130 ; 230) est reliée au boîtier (110 ; 210) et son autre extrémité est reliée à l'élément caméra (120 ; 220), l'élément à double poussée (130) comprenant en outre un élément crochet (231), un élément élastique (232) et une partie de rainure de coulissement en forme de coeur (233),
une queue (231a) de l'élément crochet (231) est reliée au boîtier (210), et une tête (231b) de l'élément crochet est disposée dans la partie de rainure de coulissement en forme de coeur (233),
l'élément élastique (232) est disposé entre le boîtier et la partie de rainure de coulissement en forme de coeur (233), et l'élément élastique (232) est configuré pour exercer une force de poussée sur la partie de rainure de coulissement en forme de coeur (233) suivant une direction allant de la queue (231a) vers la tête (231b) de l'élément crochet (231),
la partie de rainure de coulissement en forme de coeur (233) est prévue dans une rainure de coulissement (260) prévue à l'intérieur du boîtier (210) pour permettre à la partie de rainure de coulissement en forme de coeur (233) de coulisser le long de celle-ci et coulisse le long de la rainure de coulissement (260),
la partie de rainure de coulissement en forme de coeur (233) est reliée à demeure en parallèle à l'élément caméra (220), la partie de rainure de coulissement en forme de coeur (233) comprend une rainure de coulissement fermée en forme de coeur (234), la rainure de coulissement fermée (234) comprend une première rainure de coulissement en arche (235) et une seconde rainure de coulissement en arche (236), une extrémité supérieure de la première rainure de coulissement en arche (235) rejoint une extrémité supérieure de la seconde rainure de coulissement en arche (236) pour former un premier creux (238a), et une extrémité de queue de la première rainure de coulissement en arche (235) rejoint une extrémité de queue de la seconde rainure de coulissement en arche (236) pour former un second creux (238b),
la partie de rainure de coulissement en forme de coeur (233) est configurée, après que l'élément caméra (220) a reçu une opération d'enfoncement, pour
coulisser dans la direction allant de la queue (231a) vers la tête (231b) de l'élément crochet (231) sous la conduite de la force d'enfoncement, de sorte que la tête (231b) de l'élément crochet (231) coulisse du premier creux (238a) vers le second creux (238b) le long de la seconde rainure de coulissement en arche (236) pour faire passer l'élément caméra (220) du second état de rentrée à l'intérieur du boîtier (210) au premier état de saillie à partir du boîtier (210), ou
coulisser dans une direction allant de la tête (231b) vers la queue (231a) de l'élément crochet (231) sous la conduite d'une force d'enfoncement de l'opération d'enfoncement, de sorte que la tête (231b) de l'élément crochet (231) coulisse du second creux (238b) vers le premier creux (238a) le long de la première rainure de coulissement en arche (235) pour faire passer l'élément caméra (220) du premier état de saillie à partir du boîtier (210) au second étant de rentrée à l'intérieur du boîtier (210) ;
une rainure de coulissement (140 ; 250) est formée à l'intérieur du boîtier pour permettre à l'élément caméra (120 ; 220) de coulisser le long de celle-ci, la rainure de coulissement (260) destinée à permettre à la partie de rainure de coulissement en forme de coeur (233) de coulisser le long de celle-ci et la rainure de coulissement (260) permettant à la partie de rainure de coulissement en forme de coeur (233) de coulisser le long de celle-ci étant prévues en parallèle ; et
l'élément caméra (120 ; 220) est configuré, lorsqu'il reçoit une opération d'enfoncement, pour alterner entre un premier état de saillie à partir du boîtier (110 ; 210) et un second état de rentrée à l'intérieur du boîtier (110 ; 210) sous le guidage de l'élément à double poussée (130 ; 230).

2. Ensemble caméra (10) selon la revendication 1, dans lequel l'élément élastique (232) est un ressort.

3. Ensemble caméra (10) selon l'une quelconque des revendications 1 et 2, comprenant en outre une carte de circuits imprimés souple (240), dans lequel
une extrémité de la carte de circuits imprimés souple (240) est reliée électriquement à l'élément caméra (220) et son autre extrémité est reliée à un processeur ; et
la carte de circuits imprimés souple (240) est configurée pour être positionnée entre l'élément caméra (220) et une surface interne du boîtier (210) dans un état enroulé lorsque l'élément caméra (220) est dans le second état et pour être positionnée entre l'élément caméra (220) et la surface interne du boîtier (210) dans un état étiré lorsque l'élément caméra (220) est dans le premier état.

4. Ensemble caméra selon la revendication 3, comprenant en outre un commutateur de détection (260) fixé au boîtier (210), dans lequel la carte de circuits imprimés souple (240) comprend en outre deux contacts correspondant au commutateur de détection (260),
le commutateur de détection (260) est configuré pour
relier électriquement les deux contacts lorsque la carte de circuits imprimés souple (240) est à l'état enroulé pour déclencher l'envoi par la carte de circuits imprimés souple (240) d'un signal d'arrêt de l'ensemble caméra au processeur ; ou
séparer électriquement les deux contacts lorsque la carte de circuits imprimés souple (240) est à l'état étiré pour déclencher l'envoi par la carte de circuits imprimés souple (240) d'un signal de démarrage de l'ensemble caméra au processeur.

5. Ensemble caméra selon la revendication 4, dans lequel le commutateur de détection (260) est une plaque métallique comprenant deux contacts élastiques qui correspondent respectivement aux deux contacts.

6. Dispositif électronique (50), comprenant : une carte-mère (510) et un ensemble caméra (520), dans lequel
l'ensemble caméra (520) est prévu sur la carte-mère (510) ; et
l'ensemble caméra (520) est un ensemble caméra selon l'une quelconque des revendications 1 à 5.

7. Dispositif électronique (50) selon la revendication 6, dans lequel la carte-mère (510) est pourvue en outre d'un processeur (530) qui est relié à une carte de circuits imprimés souple de l'ensemble caméra (520) par l'intermédiaire d'un fil conducteur de la carte-mère (510) ;
le processor (530) est configuré pour recevoir un signal de démarrage de l'ensemble caméra envoyé par l'ensemble caméra (520) et lancer une application de caméra conformément au signal de démarrage de l'ensemble caméra ou pour recevoir un signal d'arrêt de l'ensemble caméra envoyé par l'ensemble caméra (520) et fermer l'application caméra conformément au signal d'arrêt de l'ensemble caméra.

8. Dispositif électronique (50) selon les revendications 6 ou 7, comprenant en outre une enceinte (540) qui est pourvue d'une ouverture permettant d'exposer l'ensemble caméra (520).
